# EUROPEAN PATENT APPLICATION

(11) **EP 4 503 088 A1**
(43) Date of publication of application: **05.02.2025**
(21) Application number: 23854858.0
(22) Date of filing: 10.08.2023
(51) Int. Cl.: H01J 37/075, H01J 37/22

(54) **METHOD FOR CREATING DETECTION DATA IN ELECTRON BEAM APPLICATION DEVICE, METHOD FOR SYNTHESIZING IMAGE OF IRRADIATION TARGET, PROGRAM, RECORDING MEDIUM, AND ELECTRON BEAM APPLICATION DEVICE**

(30) Priority: 15.08.2022 JP 2022129405
(71) Applicant: Photo Electron Soul Inc., Nagoya-shi, Aichi 460-0008 (JP)
(72) Inventor: NISHITANI, Tomohiro, Nagoya-shi, Aichi 460-0008 (JP); ARAKAWA, Yuta, Nagoya-shi, Aichi 460-0008 (JP); YASUFUKU, Daisuke, Nagoya-shi, Aichi 460-0008 (JP)
(74) Representative: Heyerhoff Geiger GmbH & Co. KG
(86) International application number: PCT/JP2023/029237
(87) International publication number: WO 2024/038824

(57) **Abstract**

An object is to provide a creation method of detection data used for an electron beam applicator itself to output detection data created with effective use of a grayscale range. This object can be achieved by the following creation method of detection data. The creation method of detection data includes at least two times of detection data output steps. The first detection data output step includes: a first electron beam irradiation step; a first detection step of generating a detection signal; a first light amount adjustment step; a step of repeating these steps; and a first output step. The second detection data output step includes: a first histogram calculation step of, based on the number of grayscale values in composing an image of the irradiated region or the number of grayscale values in a composed image of the irradiated region and the first light source intensity range, allocating grayscale values within a grayscale range to respective light source intensities in the first light source intensity range or allocating light source intensities within the first light source intensity range to respective grayscale values to set grayscale value-light source intensity correlation values, which associate light source intensities with grayscale values, and calculating frequencies of appearance of irradiated spots having respective grayscale value-light source intensity correlation values from the first detection data; a second detection condition setting step of, to enable effective use of the grayscale range, based on a calculated histogram, setting the light source to have a second light source intensity range and/or setting the emission quantity of the emission substance entering the detector to a second value; a second electron beam irradiation step based on the set second detection condition; a second detection step of generating a detection signal; a second light amount adjustment step; a step of repeating the above steps; and a second output step.

## Description

### [Technical Field]

The disclosure in the present application relates to a creation method of detection data and an image composition method for an irradiation target in an electron beam applicator, a program, a storage medium, and an electron beam applicator.

### [Background Art]

Electron beam applicators such as scanning electron microscopes (SEMs), inspection devices, or the like are known as devices for capturing images of samples. SEMs enable observation of microstructure of sample surfaces at the several nm level and thus have been used in many research institutions. For image capturing using SEMs, various adjustment methods for obtaining bright and high-contrast images are known. For example, a method of making an image brighter by increasing probe current to increase the quantity of secondary electrons emitted from a sample, a method of adjusting the brightness and contrast of an image by adjusting brightness and contrast adjustment buttons on the SEM control panel, and the like are known.

For inspection devices for acquiring integrated circuit pattern images of semiconductor wafers or the like, there is a demand for faster image detection as well as higher sensitivity in image detection. To meet such a demand, Patent Literature 1 discloses that, in a detection unit that detects secondary electrons emitted from an irradiated region of a reference inspection device, the detection sensitivity is adjusted in accordance with the projection magnification or the like.

The adjustment of the detection sensitivity of a detection unit is performed, for example, manually or the like with reference to a detection result on secondary electrons emitted from an irradiated region in response to irradiation with an electron beam. Therefore, for example, when adjustment is made by capturing the entire image of an irradiated region, capturing an enlarged image of a part of an irradiated region, or the like, there is a problem of a detector with a large dynamic range of detection sensitivity being required.

To solve the above problem, Patent Literature 2 discloses that (1) in a photocathode, it is possible to easily adjust the intensity (electron quantity) of an electron beam to be emitted by adjusting the light amount of received excitation light, (2) the amount of light reaching the photocathode is adjusted so that the signal intensity of the detection signal of an emission quantity related to emission from the irradiated region becomes a preset value, (3) since light amount adjustment data when the signal intensity of the detection signal becomes the preset value is data reflecting the sample state of the irradiated region, the light amount adjustment data can be used as detection data of the irradiated region, and (4) therefore, detection data of the irradiated region can be obtained even with a small dynamic range of detection sensitivity of the detector.

### [Citation List]

### [Patent Literature]

Patent Literature 1: Japanese Patent Application Laid-Open No. H11-242943
Patent Literature 2: Japanese Patent No. 6968481

### [Summary of Invention]

### [Technical Problem]

Images obtained by a SEM, or the like can be corrected such as brightened or darkened by using an image correction function such as a tone curve. However, such an image correction function is solely a function for correcting an obtained image. When detection data obtained from an electron beam applicator is data created without effective use of a grayscale range (the number of grayscale values representing steps of brightness shading) of an image composed based on the detection data, an image created without effective use of the grayscale range will be corrected even when the image correction function is used. It is thus desirable for the electron beam applicator itself to be able to output detection data created with effective use of the grayscale range. However, no method (device) is known that causes an electron beam applicator itself to output detection data created with effective use of the grayscale range.

The present application has been made in order to solve the above problem. According to an intensive study made by the present inventors, it has been newly found that (1) when an image of an irradiated region is composed, detection data obtained by the method disclosed in Patent Literature 2 may be created with ineffective use of the grayscale range of the image, (2) based on the number of grayscale values in composing an image of the irradiated region or the number of grayscale values in a composed image of the irradiated region and the first light source intensity range, grayscale values within the grayscale range are allocated to respective light source intensities of the first light source intensity range, or light source intensities within the first light source intensity range are allocated to respective grayscale values, thereby grayscale value-light source intensity correlation values associating the light source intensities with the grayscale values are set, and frequencies of appearance of irradiated spots having respective grayscale value-light source intensity correlation values are calculated from detection data obtained by the method disclosed in Patent Literature 2, and (3) based on a calculated histogram, the intensity range of the light source is adjusted and/or the emission quantity of an emission substance entering a detector is adjusted, and thereby the electron beam applicator itself can output detection data created with effective use of the grayscale range in the image composition.

The disclosure in the present application is to provide a creation method of detection data created with effective use of a grayscale range and an image composition method for an irradiation target in an electron beam applicator, a program, a storage medium, and an electron beam applicator.

### [Solution to Problem]

The present application relates to a creation method of detection data and an image composition method for an irradiation target in an electron beam applicator, a program, a storage medium, and an electron beam applicator as illustrated below.
[1] A creation method of detection data in an electron beam applicator,
   wherein the electron beam applicator includes
   a light source,
   a photocathode configured to generate releasable electrons in response to receiving light from the light source,
   an anode configured to form an electric field between the photocathode and the anode and extract the releasable electrons by the formed electric field to form an electron beam,
   a detector configured to determine an emission quantity of an emission substance emitted from an irradiation target irradiated with the electron beam, and
   a control unit,
   the creation method of detection data including at least two times of detection data output steps,
   wherein a first detection data output step includes
      a first electron beam irradiation step of irradiating an irradiation region of the irradiation target with an electron beam formed in response to receiving light from the light source set to have a first light source intensity range,
      a first detection step of determining, by the detector, the emission quantity of the emission substance emitted from respective irradiated spots in the irradiation region irradiated with the electron beam and generating a detection signal,
      a first light amount adjustment step of adjusting an amount of light reaching the photocathode from the light source within the first light source intensity range so that an emission quantity of an emission substance entering the detector becomes a preset first value,
      a step of repeating the first electron beam irradiation step, the first detection step, and the first light amount adjustment step until the emission quantity of the emission substance entering the detector becomes the preset first value, and
      a first output step of outputting light amount adjustment data as first detection data of the irradiated region, the light amount adjustment data being obtained when the emission quantity of the emission substance entering the detector becomes the first value, and
   wherein a second detection data output step includes
      a first histogram calculation step of, based on the number of grayscale values in compositing an image of the irradiated region or the number of grayscale values in a composed image of the irradiated region and the first light source intensity range, allocating grayscale values within a grayscale range to respective light source intensities in the first light source intensity range or allocating light source intensities within the first light source intensity range to respective grayscale values to set grayscale value-light source intensity correlation values, which associate light source intensities with grayscale values, and calculating frequencies of appearance of irradiated spots having respective grayscale value-light source intensity correlation values from the first detection data,
      a second detection condition setting step of, to enable effective use of the grayscale range, based on a calculated histogram, setting the light source to have a second light source intensity range and/or setting the emission quantity of the emission substance entering the detector to a second value,
      a second electron beam irradiation step of, based on a set second detection condition, irradiating the irradiation region of the irradiation target with an electron beam formed in response to receiving light from the light source,
      a second detection step of detecting, by the detector, data on the emission quantity of the emission substance emitted from respective irradiated spots in the irradiation region irradiated with the electron beam and generating a detection signal,
      a second light amount adjustment step of adjusting an amount of light reaching the photocathode from the light source within a range of the second detection condition so that the emission quantity of the emission substance entering the detector becomes a value of the second detection condition,
      a step of repeating the second electron beam irradiation step, the second detection step, and the second light amount adjustment step until the emission quantity of the emission substance entering the detector becomes the value of the second detection condition, and
      a second output step of outputting light amount adjustment data as second detection data of the irradiated region, the light amount adjustment data being obtained when the emission quantity of the emission substance entering the detector becomes the value of the second detection condition.
[2] The creation method of detection data according to [1] above, wherein the second detection data is used as detection data of the irradiated region.
[3] The creation method of detection data according to [1] further including n-2 times of detection data output step after the second detection data output step, where n is an integer of 3 or 4 or greater,
   wherein an n-th detection data output step includes
      an (n-1)-th histogram calculation step of, based on the number of grayscale values and a light source intensity range set in the (n-1)-th detection condition, allocating grayscale values within the grayscale range to respective light source intensities in the light source intensity range or allocating light source intensities within the light source intensity range to respective grayscale values to set grayscale value-light source intensity correlation values, which associate light source intensities with grayscale values, and calculating frequencies of appearance of irradiated spots having respective grayscale value-light source intensity correlation values from the (n-1)-th detection data,
      an n-th detection condition setting step of, to enable effective use of the grayscale range, based on a calculated histogram, setting the light source to have an n-th light source intensity range and/or setting the emission quantity of the emission substance entering the detector to an n-th value,
      an n-th electron beam irradiation step of, based on a set n-th detection condition, irradiating the irradiation region of the irradiation target with an electron beam formed in response to receiving light from the light source,
      an n-th detection step of detecting, by the detector, data on the emission quantity of the emission substance emitted from respective irradiated spots in the irradiation region irradiated with the electron beam and generating a detection signal,
      an n-th light amount adjustment step of adjusting an amount of light reaching the photocathode from the light source within a range of the n-th detection condition so that the emission quantity of the emission substance entering the detector becomes a value of the n-th detection condition,
      a step of repeating the n-th electron beam irradiation step, the n-th detection step, and the n-th light amount adjustment step until the emission quantity of the emission substance entering the detector becomes the value of the n-th detection condition, and
      an n-th output step of outputting light amount adjustment data as n-th detection data of the irradiated region, the light amount adjustment data being obtained when the emission quantity of the emission substance entering the detector becomes the value of the n-th detection condition, and
   wherein when n is an integer of 4 or greater, the n-th detection data output step is performed n-2 times sequentially from n=3.
[4] The creation method of detection data according to [3] above, wherein n-th output detection data is used as detection data of the irradiated region.
[5] The creation method of detection data according to [1] above, wherein setting of the second light source intensity range includes any one selected from a group consisting of
   (1) when the frequency of appearance of an irradiated spot having light source intensity data corresponding to grayscale value 0 is 0, setting the maximum value of the second light source intensity range to be smaller than the maximum value of the first light source intensity range,
   (2) when the frequency of appearance of an irradiated spot having light source intensity data corresponding to the maximum grayscale value is 0, setting the minimum value of the second light source intensity range to be larger than the minimum value of the first light source intensity range,
   (3) when the frequency of appearance of an irradiated spot having light source intensity data corresponding to grayscale value 0 is greater than 0, setting the maximum value of the second light source intensity range to be larger than the maximum value of the first light source intensity range, and
   (4) when the frequency of appearance of an irradiated spot having light source intensity data corresponding to the maximum grayscale value is greater than 0, setting the minimum value of the second light source intensity range to be smaller than the minimum value of the first light source intensity range.
[6] The creation method of detection data according to [1] above, wherein setting of the second value includes
   (5) when moving a peak position of the frequency of appearance of an irradiated spot to the grayscale value 0 side, setting the emission quantity of the emission substance entering the detector to be larger than the first value, or
   (6) when moving a peak position of the frequency of appearance of an irradiated spot to the maximum grayscale value side, setting the emission quantity of the emission substance entering the detector to be smaller than the first value.
[7] The creation method of detection data according to any one of [1] to [6] above, wherein the electron beam applicator is
   a scanning electron microscope,
   an electron beam inspection device,
   an Auger electron spectrometer,
   a cathodoluminescence device,
   an X-ray analyzer,
   a transmission electron microscope, or
   a scanning transmission electron microscope.
[8] An image composition method for an irradiation target in an electron beam applicator, the image composition method including:
   an image composition step of composing an image of an irradiated region of the irradiation target from detection data obtained by the creation method of detection data according to any one of [1] to [6] above.
[9] A program that causes the control unit of the electron beam applicator to perform each step according to any one of [1] to [6] above.
[10] A computer readable storage medium storing the program according to [8] above.
[11] An electron beam applicator including:
   a light source;
   a photocathode configured to generate releasable electrons in response to receiving light from the light source;
   an anode configured to form an electric field between the photocathode and the anode and extract the releasable electrons by the formed electric field to form an electron beam;
   a detector configured to determine an emission quantity of an emission substance emitted from an irradiation target irradiated with the electron beam; and
   a control unit,
   wherein the program according to [9] above is stored in the control unit.
[12] The electron beam applicator according to [11] above, wherein the control unit implements control to perform an image composition step of composing an image of an irradiated region of the irradiation target from the detection data.
[13] The electron beam applicator according to [11] above, wherein the electron beam applicator is
   a scanning electron microscope,
   an electron beam inspection device,
   an Auger electron spectrometer,
   a cathodoluminescence device,
   an X-ray analyzer,
   a transmission electron microscope, or
   a scanning transmission electron microscope.

### [Advantageous Effect]

With the use of the creation method of detection data and the image composition method for an irradiation target in the electron beam applicator, the program, the storage medium, and the electron beam applicator disclosed in the present application, the electron beam applicator itself can output detection data created with effective use of a grayscale range.

### [Brief Description of Drawings]

[FIG. 1] FIG. 1 is a diagram schematically illustrating an electron beam applicator 1 according to an embodiment.
[FIG. 2A] FIG. 2A is a diagram illustrating an overview of adjustment of the detection sensitivity in a conventional electron beam applicator.
[FIG. 2B] FIG. 2B is a diagram illustrating an overview of adjustment of the detection sensitivity in the conventional electron beam applicator.
[FIG. 2C] FIG. 2C is a diagram illustrating an overview of adjustment of the detection sensitivity in the conventional electron beam applicator.
[FIG. 2D] FIG. 2D is a diagram illustrating an overview of adjustment of the detection sensitivity in the conventional electron beam applicator.
[FIG. 3A] FIG. 3A is a diagram illustrating the principle of a detection data creation method disclosed in the present application.
[FIG. 3B] FIG. 3B is a diagram illustrating the principle of the detection data creation method disclosed in the present application.
[FIG. 3C] FIG. 3C is a diagram illustrating the principle of the detection data creation method disclosed in the present application.
[FIG. 4] FIG. 4 is a flowchart of the detection data creation method.
[FIG. 5] FIG. 5 is a diagram illustrating an example of a histogram calculated in a first (n-th) histogram calculation step of the detection data creation method disclosed in the present application.
[FIG. 6A] FIG. 6A is a diagram illustrating an overview of a second detection condition setting step of the detection data creation method disclosed in the present application.
[FIG. 6B] FIG. 6B is a diagram illustrating an overview of the second detection condition setting step of the detection data creation method disclosed in the present application.
[FIG. 7A] FIG. 7A is a diagram illustrating an overview of the second detection condition setting step of the detection data creation method disclosed in the present application.
[FIG. 7B] FIG. 7B is a diagram illustrating an overview of the second detection condition setting step of the detection data creation method disclosed in the present application.
[FIG. 8] FIG. 8 is a diagram illustrating an overview of the second detection condition setting step of the detection data creation method disclosed in the present application.
[FIG. 9] FIG. 9 is a diagram illustrating an overview of the second detection condition setting step of the detection data creation method disclosed in the present application.
[FIG. 10] FIG. 10 includes photographs substituted for drawings. FIG. 10A illustrates a SEM image based on a detection signal output from a detector 5 in Comparative example 2. FIG. 10B illustrates an image composed based on first detection data in Comparative example 2. FIG. 10C illustrates an image composed by inverting light source intensities in the first detection data in Comparative example 2 (SEM equivalent image).
[FIG. 11] FIG. 11 includes photographs substituted for drawings. FIG. 11A illustrates a SEM image based on a detection signal output from the detector 5 in Example 2. FIG. 11B illustrates an image composed based on first detection data in Example 2. FIG. 11C illustrates an image composed by inverting light source intensities in the first detection data in Example 2 (SEM equivalent image) .
[FIG. 12] FIG. 12 includes photographs substituted for drawings. FIG. 12A illustrates a SEM image captured in Comparative example 3. FIG. 12B illustrates a SEM equivalent image of Comparative example 2. FIG. 12C illustrates a SEM equivalent image of Example 2.
[FIG. 13] FIG. 13A, FIG. 13B, and FIG. 13C are histograms representing frequencies of appearance of pixels corresponding to respective grayscale values of a grayscale range of 0 to 255 in the SEM image of FIG. 12A and the SEM equivalent images of FIG. 12B and FIG. 12C, respectively.
[FIG. 14] FIG. 14 includes photographs substituted for drawings. FIG. 14A illustrates a SEM image based on a detection signal output from the detector 5 in Example 3. FIG. 14B illustrates an image composed based on first detection data in Example 3. FIG. 14C illustrates an image composed by inverting light source intensities in the first detection data in Example 3 (SEM equivalent image) .
[FIG. 15] FIG. 15 includes photographs substituted for drawings. FIG. 15A illustrates a SEM image based on a detection signal output from the detector 5 in Example 4. FIG. 15B illustrates an image composed based on first detection data in Example 4. FIG. 15C illustrates an image composed by inverting light source intensities in the first detection data in Example 4 (SEM equivalent image) .
[FIG. 16] FIG. 16 includes photographs substituted for drawings. FIG. 16A illustrates a SEM equivalent image of Comparative example 2. FIG. 16B illustrates a SEM equivalent image of Example 3. FIG. 16C illustrates a SEM equivalent image of Example 4.
[FIG. 17] FIG. 17A, FIG. 17B, and FIG. 17C are histograms representing frequencies of appearance of pixels corresponding to respective grayscale values of a grayscale range of 0 to 255 in the SEM equivalent images of FIG. 16A, FIG. 16B, and FIG. 16C, respectively.

### [Description of Embodiments]

A creation method of detection data (hereafter, which may be referred to as "detection data creation method") and an image composition method for an irradiation target in an electron beam applicator, a program, a storage medium, and an electron beam applicator will be described in detail below with reference to the drawings. Note that, in the present specification, members having the same type of functions are labeled with the same or similar references. Further, duplicated description for the members labeled with the same or similar references may be omitted.

Further, the position, size, range, or the like of respective components illustrated in the drawings may be depicted differently from the actual position, size, range, or the like for easier understanding. Thus, the disclosure in the present application is not necessarily limited to the position, size, range, or the like disclosed in the drawings.

### [Embodiment of Electron Beam Applicator and Detection Data Creation Method]

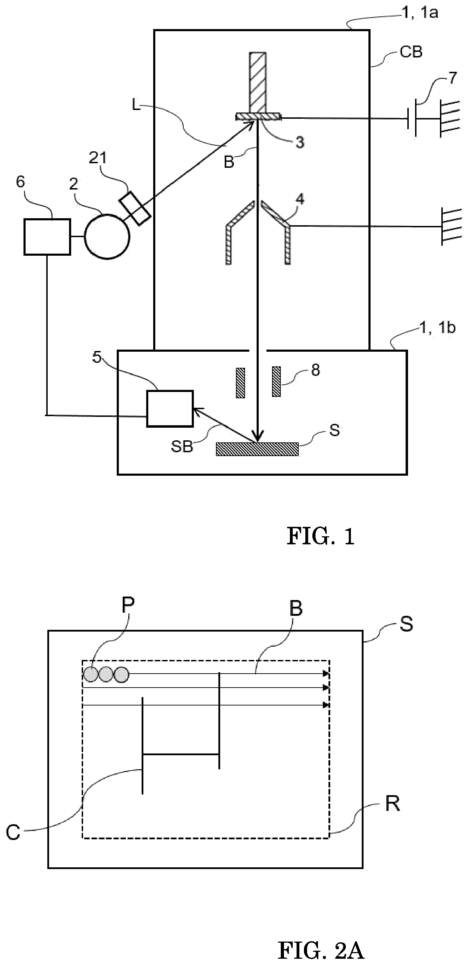

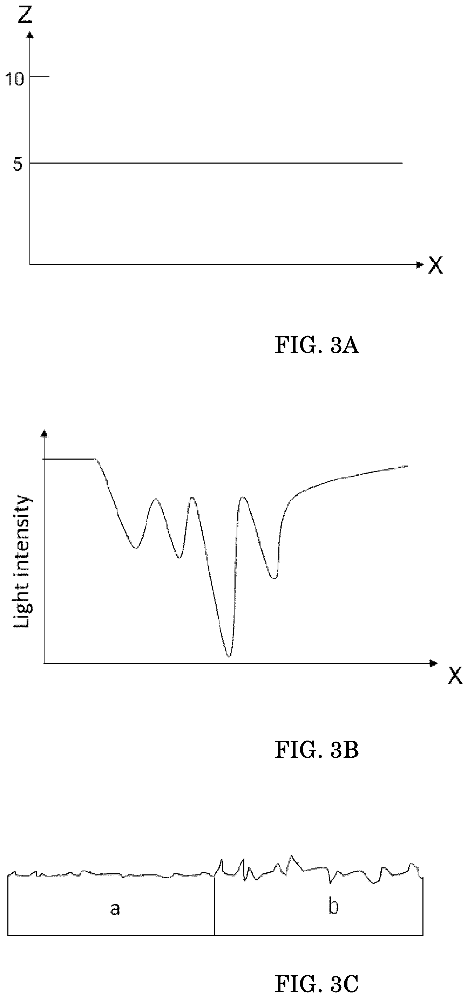

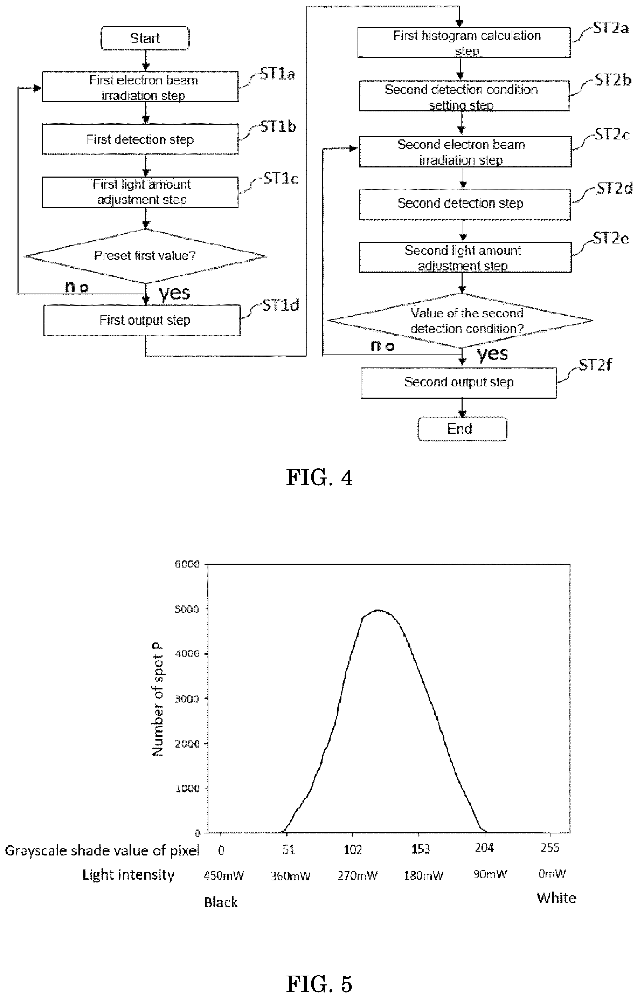

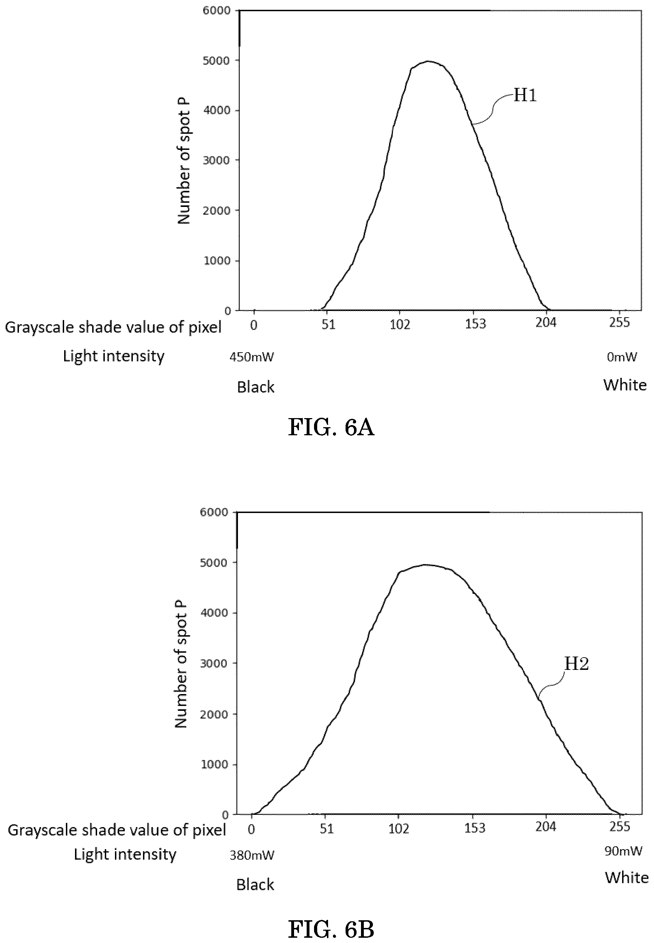

Embodiments of the electron beam applicator and the detection data creation method will be described with reference to FIG. 1 to FIG. 9. FIG. 1 is a diagram schematically illustrating an electron beam applicator 1 according to the embodiment. FIG. 2A to FIG. 2D are diagrams illustrating the overview of adjustment of the detection sensitivity in the conventional electron beam applicator. FIG. 3A to FIG. 3C are diagrams illustrating the principle of the detection data creation method disclosed in the present application. FIG. 4 is a flowchart of the detection data creation method. FIG. 5 is a diagram illustrating an example of a histogram calculated in the first (n-th) histogram calculation step. FIG. 6 to FIG. 9 are diagrams illustrating the overview of a second detection condition setting step.

The embodiment of the electron beam applicator 1 illustrated in FIG. 1 includes at least a light source 2, a photocathode 3, an anode 4, a detector 5, and a control unit 6. Note that FIG. 1 illustrates an example in which the electron beam applicator 1 is formed separately of an electron gun portion 1a and a counterpart device 1b (the remaining portion of the electron beam applicator 1 when the electron gun portion 1a is removed). Alternatively, the electron beam applicator 1 may be formed in an integrated manner. Further, the electron beam applicator 1 may be optionally, additionally provided with a power supply 7 for generating an electric field between the photocathode 3 and the anode 4 and an electron beam deflector 8 for scanning the electron beam B on an irradiation target S. Furthermore, although depiction is omitted, a known component in accordance with the type of the electron beam applicator 1 may be included.

The light source 2 is not particularly limited as long as it can irradiate the photocathode 3 with excitation light L to cause emission of the electron beam B. The light source 2 may be, for example, a high power (watt class), high frequency (several hundred MHz), ultrashort pulse laser light source, a relatively inexpensive laser diode, an LED, or the like. The excitation light L for irradiation can be either pulsed light or continuous light and can be adjusted as appropriate in accordance with purposes. Note that, in the example illustrated in FIG. 1, the light source 2 is arranged outside a vacuum chamber CB, and a first face (a face on the anode 4 side) side of the photocathode 3 is irradiated with the excitation light L. Alternatively, the light source 2 may be arranged inside the vacuum chamber CB. Further, a second face (a face on the opposite side of the anode 4) side of the photocathode 3 may be irradiated with the excitation light L.

The photocathode 3 generates releasable electrons in response to receiving the excitation light L irradiated from the light source 2. The principle of the photocathode 3 generating releasable electrons in response to receiving the excitation light L is well known (for example, see Japanese Patent No. 5808021 and the like).

The photocathode 3 is formed of a substrate of quartz glass, sapphire glass, or the like and a photocathode film (not illustrated) adhered to the first face (the face on the anode 4 side) of the substrate. The photocathode material for forming the photocathode film is not particularly limited as long as it can generate releasable electrons in response to irradiation with excitation light and may be a material requiring EA surface treatment, a material not requiring EA surface treatment, or the like. The material requiring EA surface treatment may be, for example, Group III-V semiconductor materials or Group II-VI semiconductor materials. Specifically, the material may be AlN, Ce₂Te, GaN, a compound of one or more types of alkaline metals and Sb, or AlAs, GaP, GaAs, GaSb, InAs, or the like, and a mixed crystal thereof, or the like. The material may be a metal as another example and specifically may be Mg, Cu, Nb, LaB₆, SeB₆, Ag, or the like. The photocathode 3 can be fabricated by applying EA surface treatment on the photocathode material described above. For the photocathode 3, suitable selection of the semiconductor material or the structure thereof makes it possible not only to select excitation light in a range from near-ultraviolet to infrared wavelengths in accordance with gap energy of the semiconductor but also to achieve electron beam source performance (quantum yield, durability, monochromaticity, time response, spin polarization) in accordance with the use of the electron beam.

Further, the material not requiring EA surface treatment may be, for example, a single metal, an alloy, or a metal compound of Cu, Mg, Sm, Tb, Y, or the like or diamond, WBaO, Cs₂Te, or the like. The photocathode not requiring EA surface treatment can be fabricated by a known method (for example, see Japanese Patent No. 3537779 and the like). The content disclosed in Japanese Patent No. 3537779 is incorporated in the present specification in its entirety by reference.

Note that, regarding the reference to "photocathode" and "cathode" in the present specification, "photocathode" may be used when the reference in question means emission of the electron beam, and "cathode" may be used when the reference in question means the counter electrode of an "anode". Regarding the reference numeral, however, "3" is used for both cases of "photocathode" and "cathode".

The anode 4 is not particularly limited as long as it can generate an electric field together with the cathode 3, and any anode 4 generally used in the field of electron guns can be used. When an electric field is formed between the cathode 3 and the anode 4, the releasable electrons generated by irradiation with the excitation light L are extracted from the photocathode 3, and thereby the electron beam B is formed.

Although FIG. 1 illustrates the example in which the power supply 7 is connected to the cathode 3 in order to form an electric field between the cathode 3 and the anode 4, the arrangement of the power supply 7 is not particularly limited as long as a potential difference occurs between the cathode 3 and the anode 4.

The detector 5 determines the emission quantity of an emission substance SB emitted from the irradiation target S irradiated with the electron beam B. The emission substance SB means a signal issued from the irradiation target S in response to irradiation with the electron beam B and may represent, for example, secondary electrons, reflected electrons, characteristic X-rays, Auger electrons, cathodoluminescence, transmitted electrons, or the like. The detector 5 is not particularly limited as long as it can detect emission of these emission substance SB, and a known detector and a known detection method can be used.

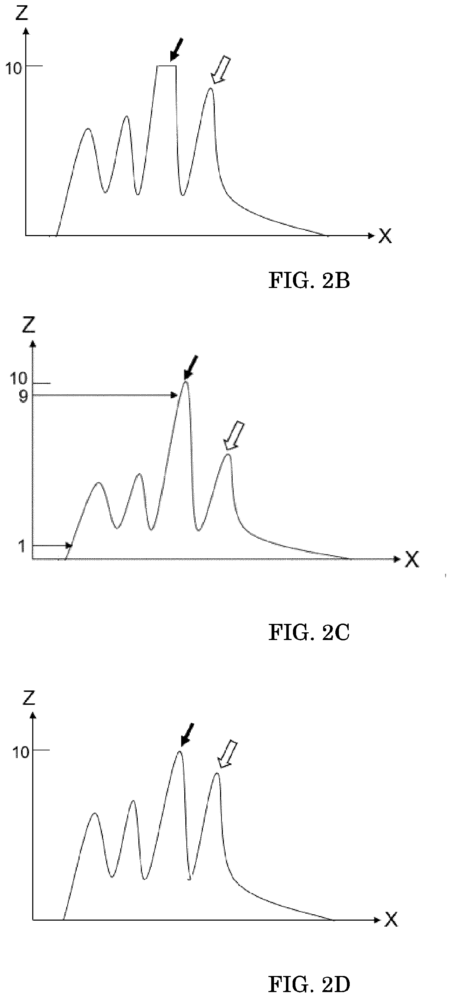

Next, the reason why data created by the detection data creation method (in other words, details of control of the control unit 6) disclosed in the present application can be used as detection data of an irradiated region R will be described with reference to FIG. 2 and FIG. 3. FIG. 2A is a diagram of the irradiation target S when viewed from the photocathode 3 side. The electron beam applicator 1 illustrated in FIG. 2A irradiates the irradiation region R of the irradiation target S with the electron beam B linearly while deflecting the electron beam B. The circle symbols represented by references P in FIG. 2A represent respective electron beams irradiated on the irradiation target S. Note that, in FIG. 2A, only some of the electron beams B are represented. Further, the irradiation region irradiated with each electron beam illustrated with reference P may be referred to as "irradiated spot P". When unevenness due to, for example, a circuit C or the like is formed in the irradiation region R and the intensities of irradiating electron beams B are the same, the emission quantity of the emission substance SB emitted from the unevenness portion differs from that in the remaining portions. That is, it is possible to measure the emission quantity of the emission substance SB on an irradiated spot P basis. Therefore, as illustrated in FIG. 2B, when the emission quantities of the emission substance SB emitted from the irradiation target S are determined on an irradiated spot P basis by the detector 5 in time series (X), the unevenness portion can be detected as a difference in the intensity (Z) of detection signals based on a difference in emission quantities of the emission substance entering the detector 5 (hereafter, an electron beam applicator employing such a detection method may be referred to as "conventional electron beam applicator") .

In the conventional electron beam applicator 1, when the intensity of the emission quantity of the emission substance SB of a certain portion in the irradiated region R exceeds the maximum value of the signal that can be processed by the detector 5 (the upper limit value of the dynamic range, namely, "10" on the vertical axis in the example illustrated in FIG. 2B), a peak that is supposed to be obtained may be unable to be detected as illustrated with the black arrow in FIG. 2B. In such a case, in the conventional electron beam applicator 1, the detection sensitivity of the detector 5 is adjusted so that the peak supposed to be obtained can be detected. However, when the detection sensitivity is adjusted (reduced) so that the peak supposed to be obtained can be detected, this will cause a problem that, although the peak indicated by the black arrow in FIG. 2B can be detected as illustrated in FIG. 2C, the detection intensity of the peak indicated by the white arrow will decrease.

Thus, the conventional electron beam applicator 1 may combine an image such that, as illustrated in FIG. 2D, out of the data illustrated in FIG. 2B, data within the dynamic range is used without change, and the data illustrated in FIG. 2C with a reduced detection sensitivity is used for the data part exceeding the dynamic range in FIG. 2B. However, such a case will cause a problem that, for example, in the example illustrated in FIG. 2D, the peaks indicated by the solid arrow and the white arrow are substantially the same and this does not accurately reflect the state of the actual irradiated region **R.**

In contrast, in the detection data creation method disclosed in the present application, as illustrated in FIG. 3A, the amount of light reaching the photocathode 3 from the light source 2 is adjusted so that the emission quantity of the emission substance SB entering the detector 5 becomes a preset value. FIG. 3A illustrates an example in which the preset value of the emission quantity of the emission substance SB entering the detector 5 is the same regardless of the position in the irradiated region R (in other words, the intensities Z of detection signals are the same, namely, the intensity Z is 5 in the example illustrated in FIG. 3A). The fact that the signal intensities of detection signals are the same despite the unevenness in the irradiated region R means that the amount of light reaching the photocathode 3 from the light source 2 has been adjusted in accordance with the unevenness in the irradiated region R, as illustrated in FIG. 3B. This will be more specifically described with reference to FIG. 2C, FIG. 3A, and FIG. 3B. For example, to obtain a detection signal having an intensity Z of 5 as illustrated in FIG. 3A from an irradiated spot P at which the intensity Z of the detection signal is 1 in FIG. 2C by using the conventional electron beam applicator, it is necessary to increase the intensity of the electron beam B irradiated on the irradiation spot P, in other words, it is necessary to increase the amount of light reaching the photocathode 3. On the other hand, to obtain a detection signal having an intensity Z of 5 as illustrated in FIG. 3A from an irradiated spot P at which the intensity Z of the detection signal is 9 in FIG. 2C by using the conventional electron beam applicator, it is necessary to reduce the intensity of the electron beam B irradiated on the irradiation spot P, in other words, it is necessary to reduce the amount of light reaching the photocathode 3. That is, the light source intensity (Light intensity) data illustrated in FIG. 3B will be data having intensity levels inverted from the data having the intensity Z of detection signals illustrated in FIG. 2C. Therefore, the light amount adjustment data illustrated in FIG. 3B in which the amount of light reaching the photocathode 3 has been adjusted so that the signal intensities of detection signals illustrated in FIG. 3A are the same will be data reflecting the sample state of the irradiated region R. Thus, the light amount adjustment data can be used as detection data of the irradiated region R. Note that, although the description has been provided with the example of unevenness due to a circuit or the like in FIG. 2A, the detection data creation method disclosed in the present application can be used for any objects as long as the emission quantity of the emission substance SB varies in accordance with the state of the sample, such as an element composition difference, a distribution of elements, a shape, a physical property, or the like.

For example, when the electron beam applicator 1 is an electron beam inspection device that inspects a semiconductor circuit or the like, since the detection data is data reflecting the sample state of the irradiated region R as described above, the presence or absence of a defect or the like in the semiconductor circuit can be inspected based on the detection data. Further, when the electron beam applicator 1 is a scanning electron microscope (SEM), the image of the irradiated region R can be composed based on the detection data. Note that the detection data is the data reflecting the sample state of the irradiated region R, and thus, in the image composition, while image composition can be performed so as to accurately reflect the sample state of the irradiated region R, image composition may be performed with partial processing as illustrated in FIG. 2D where necessary. The image composition method is not particularly limited as long as it is apparent how the composed image reflects the detection data.

Note that, although FIG. 3A illustrates an example in which the preset value for the emission quantity of the emission substance SB entering the detector 5 (the signal intensity of the detection signal) is the same regardless of the position in the irradiated region R, the preset value may not be the same. For example, when the irradiated region R includes regions of apparently different sample states as indicated by "a" and "b" in FIG. 3C, a different value in accordance with the region may be used as the preset value.

Further, when the electron beam applicator 1 is a scanning electron microscope, it may be desirable to reduce the amount of an electron beam irradiated on a particular region in order to avoid charging-up of the irradiated region R. As illustrated for the detection data creation method described later, the control unit 6 repeats an electron beam irradiation step, a detection step, and a light amount adjustment step until the emission quantity of the emission substance SB entering the detector 5 becomes the preset value. That is, since the control unit 6 performs feedback control on the amount of light based on the detection signal, it is possible to always store the relationship between the irradiation position of the electron beam B, the detection signal, and the amount of light. Therefore, even when the emission quantity of the emission substance SB entering the detector 5 differs (in other words, the detection signal intensity differs) for only a particular region, the data reflecting the sample state of the irradiated region R is obtained by analyzing the detection data based on the relationship between the stored irradiation position of the electron beam B, the stored detection signal, and the stored amount of light.

Although the above embodiment has been described with an example in which the electron beam applicator 1 is a scanning electron microscope and an electron beam inspection device, the electron beam applicator 1 is not particularly limited as long as it can detect secondary electrons, reflected electrons, characteristic X-rays, Auger electrons, cathodoluminescence, or transmitted electrons. The electron beam applicator 1 other than a scanning electron microscope and an electron beam inspection device may be, for example, an Auger electron spectrometer, a cathodoluminescence device, an X-ray analyzer, a transmission electron microscope (TEM), a scanning transmission electron microscope (STEM), or the like.

Note that FIG. 2A illustrates the example of the scanning type electron beam applicator that irradiates the irradiation region R of the irradiation target S with the electron beam B while deflecting the electron beam B. Alternatively, the position of the excitation light L irradiated on the photocathode 3 from the light source 2 may be scanned. Further alternatively, the photocathode 3 may be irradiated with multiple excitation lights. Even when scanning with the excitation light L is performed or irradiation with multiple excitation lights L is simultaneously performed, light amount adjustment data reflecting the sample state of the irradiated region R is obtained by adjusting the amount of light reaching the photocathode 3 from the light source 2 so that the emission quantity of the emission substance SB emitted from the irradiated region R is the preset value.

Next, differences between the detection data creation method disclosed in the present application and the detection data creation method disclosed in Patent Literature 2 will be described in detail with reference to FIG. 4 to FIG. 9. The detection data creation method disclosed in the present application includes at least two times of detection data output steps of a first detection data output step and a second detection data output step.

The first detection data output step includes a first electron beam irradiation step (ST1a), a first detection step (ST1b), a first light amount adjustment step (ST1c), and a first output step (ST1d).

The first electron beam irradiation step (ST1a) is to irradiate the irradiation region R of the irradiation target S with the electron beam B formed in response to receiving light from the light source 2 set to have a first light source intensity range. The first light source intensity range is not particularly limited as long as it is within an intensity range that can be taken by the light source 2. As described later, given that the light source intensity range may be changed to perform the second detection data output step, when the intensity range that can be taken by the light source 2 is defined as 100%, for example, the lower limit value of the intensity range of the light source 2 may be increased by 5%, 10%, 15%, 20%, 25%, 30%, 35%, or 40% from 0, and the upper limit value of the intensity of the light source 2 may be reduced by 5%, 10%, 15%, 20%, 25%, 30%, 35%, or 40% from the maximum value.

The first detection step (ST1b) is to determine, by the detector 5, the emission quantity of the emission substance SB emitted from the irradiation region S irradiated with the electron beam B and generate a first detection signal. The first light amount adjustment step (ST1c) is to adjust the amount of light reaching the photocathode 3 from the light source 2 so that the emission quantity of the emission substance SB entering the detector 5 becomes a preset first value. The first value is not particularly limited as long as the emission quantity of the emission substance SB entering the detector 5 is within the dynamic range of the detector 5. As described later, given that the emission quantity of the emission substance SB entering the detector 5 may be changed to perform the second detection data output step, when the dynamic range of the detector 5 is defined as 100%, for example, the first value may be the median in the dynamic range, alternatively, to a value on the lower sensitivity side by 5%, 10%, 15%, 20%, 25%, 30%, 35%, or 40% from the median, alternatively, to a value on the higher sensitivity side by 5%, 10%, 15%, 20%, 25%, 30%, 35%, or 40% from the median, or the like. Note that the first light amount adjustment step is not particularly limited as long as the amount of light reaching the photocathode 3 from the light source 2 can be adjusted within the first light source intensity range. For example, the amount of light can be adjusted by direct control of the power of the light source 2. Further, a light amount adjustment member 21 such as a liquid crystal shutter may be arranged between the light source 2 and the photocathode 3, and the control unit 6 may control the light amount adjustment member 21 to adjust the amount of light reaching the photocathode 3. When the control unit 6 controls the light amount adjustment member 21, the adjustment data on the light amount adjustment member 21 will be data reflecting the sample state of the irradiated region R.

The first electron beam irradiation step (ST1a), the first detection step (ST1b), and the first light amount adjustment step (ST1c) can be repeated until the emission quantity of the emission substance SB entering the detector 5 becomes the preset first value. In the first output step (ST1d), the light amount adjustment data when the emission quantity of the emission substance SB entering the detector 5 becomes the preset first value is output as the first detection data of the irradiated region R.

The second detection data output step includes a first histogram calculation step (ST2a), a second detection condition setting step (ST2b), a second electron beam irradiation step (ST2c), a second detection step (ST2d), a second light amount adjustment step (ST2e), and a second output step (ST2f).

The first histogram calculation step (ST2a) will be described with reference to FIG. 5. FIG. 5 illustrates an example in which the number of grayscale values in actually composing an image of irradiated region R (an aggregate of irradiated spots P) is 256 including 0 to 255 and the first light source intensity range is from 0 mW to 450 mW. The first histogram calculation step (ST2a) is to, based on the number of grayscale values in composing an image of the irradiated region R and on the first light source intensity range, allocate grayscale values within the grayscale range to respective light source intensities in the first light source intensity range or allocate light source intensities within the first light source intensity range to respective grayscale values to set a grayscale value-light source intensity correlation value that associates light source intensities with grayscale values.

Note that, in the present specification, ""the number" of "grayscale values in composing an image"" means "the number" of "grayscale values set by a user expecting image composition". That is, in the present specification, when the expression "in composing an image" is used, no image is actually composed. In contrast, in the present specification, the expression "composed image" is used when an image has been actually composed.

Note that the grayscale value in a composed image composed based on the first detection data described in Patent Literature 2 may be used to set the grayscale value-light source intensity correlation value that associates light source intensities with grayscale values in accordance with the same procedure as the above and calculate a histogram. That is, in the present specification, "grayscale value" of the "grayscale value-light source intensity correlation value" is a concept including both "grayscale value in composing an image" and "grayscale value in a composed image". Further, when visualized as a histogram, "grayscale value in composing an image" and "grayscale value in a composed image" are the same in terms of the horizontal axis. Therefore, in a diagram representing a histogram, both "grayscale value in composing an image" and "grayscale value in a composed image" are stated as "grayscale shade value of pixel". Further, for the vertical axis of a diagram representing a histogram, when the horizontal axis is "grayscale value in composing an image", the frequency of appearance of the irradiated spot P (Number of spot P) is stated, and when the horizontal axis is "grayscale value in a composed image", the frequency of appearance of pixels (Number of pixels) is stated.

First, an example of allocating grayscale values within the grayscale range to respective light source intensities in the first light source intensity range to set a grayscale value-light source intensity correlation value will be described. As described above, the light source intensity (Light intensity) data is data having inverted data on the intensity Z of detection signals obtained by the conventional electron beam applicator. Therefore, in the example illustrated in FIG. 5, the light source intensity of 450 mW, which is the maximum value in the first light source intensity range, is set for grayscale value 0 (Black) in actually composing an image, the light source intensity of 0 mW, which is the minimum value in the first light source intensity range, is set for grayscale value 255 (White) in actually composing an image, and thereby grayscale values are allocated to respective light source intensity data in the first light source intensity range. Note that, in the present specification, when "grayscale values are allocated to respective light source intensity data" is stated, the allocated grayscale values each are not necessarily required to be an integer. For example, in the example illustrated in FIG. 5, grayscale value 0 is allocated to 450 mW, grayscale value 51 is allocated to 360 mW, grayscale value 102 is allocated to 270 mW, grayscale value 153 is allocated to 180 mW, grayscale value 204 is allocated to 90 mW, and grayscale value 255 is allocated to 0 mW. Although not illustrated in FIG. 5, with a more detailed view, allocation is made such that a grayscale value of 0.566 is added as the light source intensity decreases by 1 mW, such as grayscale value 0.57 being allocated to 449 mW, grayscale value 1.13 being allocated to 448 mW, and the like. Further, in the present specification, when "grayscale values are allocated to respective light source intensity data" is stated, the number of divisions of the light source intensity data is not particularly limited as long as it is greater than the number of grayscale values. For example, in the example illustrated in FIG. 5, although grayscale values are allocated by every 1 mW of the light source intensity, grayscale values may be allocated by every 0.5 mW of the light source intensity or by every 1.5 mW of the light source intensity.

Next, an example of allocating light source intensities within the first light source intensity range to respective grayscale values to set a grayscale value-light source intensity correlation value will be described. In the example illustrated in FIG. 5, 450 mW, which is the maximum value in the first light source intensity range, is set for grayscale value 0 (Black) in actually composing an image, 0 mW, which is the minimum value in the first light source intensity range, is set for grayscale value 255 (White) in actually composing an image, and thereby light source intensity data are allocated to respective grayscale values. For example, in the example illustrated in FIG. 5, 450 mW is allocated to grayscale value 0, 360 mW is allocated to grayscale value 51, 270 mW is allocated to grayscale value 102, 180 mW is allocated to grayscale value 153, 90 mW is allocated to grayscale value 204, and 0 mW is allocated to grayscale value 255. Although not illustrated in FIG. 5, with a more detailed view, allocation is made such that a light source intensity decreases by 1.765 mW as the grayscale value increases by 1, such as 448.24 mW being allocated to grayscale value 1, 446.47 mW being allocated to grayscale value 2, and the like.

In the example illustrated in FIG. 5, the horizontal axis represents the grayscale value-light source intensity correlation value that associates each light source intensity within the first light source intensity range with each grayscale value. Therefore, by calculating the frequency of appearance of the irradiated spot P based on the light source intensity data on an irradiated spot P basis, it is possible to calculate the frequency of appearance of the irradiated spot P corresponding to each grayscale value in composing an image from the first detection data without actually composing an image, as illustrated in FIG. 5.

Further, as described later in "Embodiment of Image Composition Method for Irradiation Target in Electron Beam Applicator", a light source intensity at the irradiated spot P and a SEM image are associated with each other. Therefore, calculation of the frequency of appearance of a pixel based on "grayscale value in a composed image" means substantially the same as the frequency of appearance of the irradiated spot P illustrated in FIG. 5.

In the example illustrated in FIG. 5, actually composing an image of the irradiated region R from the first detection data means that the smaller grayscale value (Black) side and the larger grayscale value (White) side are not used. Note that, when the frequency of appearance of the irradiated spot P has been calculated by using "grayscale values in composing an image", since the histogram calculation step can be performed directly from the first detection data, the histogram calculation step can be quickly performed. In contrast, when a histogram of pixels has been calculated by composing an image based on the first detection data and using the grayscale value in the composed image, the histogram calculation step can be performed after the user observes the composed image. Further, although the example illustrated in FIG. 5 is set such that grayscale value 0 corresponds to 450 mW, which is the maximum value in the first light source intensity range, and the maximum value 255 of the grayscale values corresponds to 0 mW, which is the minimum value in the first light source intensity, the disclosure is not limited to such an example. For example, even when numerical values at both ends of the first light source intensity range and numerical values at both ends of the grayscale values are slightly shifted, such as grayscale value 0 being shifted to a value on the maximum value side in the first light source intensity range (for example, 440 mW), the maximum value 255 of the grayscale values being shifted to a value on the minimum value side in the first light source intensity range (for example, 10 mW), or the like, such a shift does not matter as long as the shift is within the technical concept disclosed in the present application.

FIG. 5 is a diagram illustrating the overview of the first histogram calculation step. In the first histogram calculation step (ST2a), although creation of a graph that is visible to the operator as illustrated in FIG. 5 is not essential, a histogram graph visualized as illustrated in FIG. 5 may be created so that the histogram graph is visible to the user of the electron beam applicator 1. Alternatively, only the information about which portion of the grayscale range is not effectively used when an image has been composed based on the light amount adjustment data (in the example illustrated in FIG. 5, information on the light source intensities of about 0 to 90 mW and about 380 mW to 450 mW, the grayscale values of 0 to about 40 and about 205 to 255, or the like) may be provided, and the second detection condition setting step may be performed based on the provided information. Further, although FIG. 5 illustrates the example of the grayscale range including 256 grayscale values, the number of grayscale values included in a grayscale range is not limited to 256. For the number of grayscale values, numbers common in this technical field can be used, which may be, for example, 128, 512, 1024, 2048, 4096, or the like.

The second detection condition setting step (ST2b) is to set the light source 2 to have the second light source intensity range and/or set the emission quantity of the emission substance SB entering the detector 5 to be the second value based on the calculated histogram in order to enable effective use of the grayscale range when composing images from detection data.

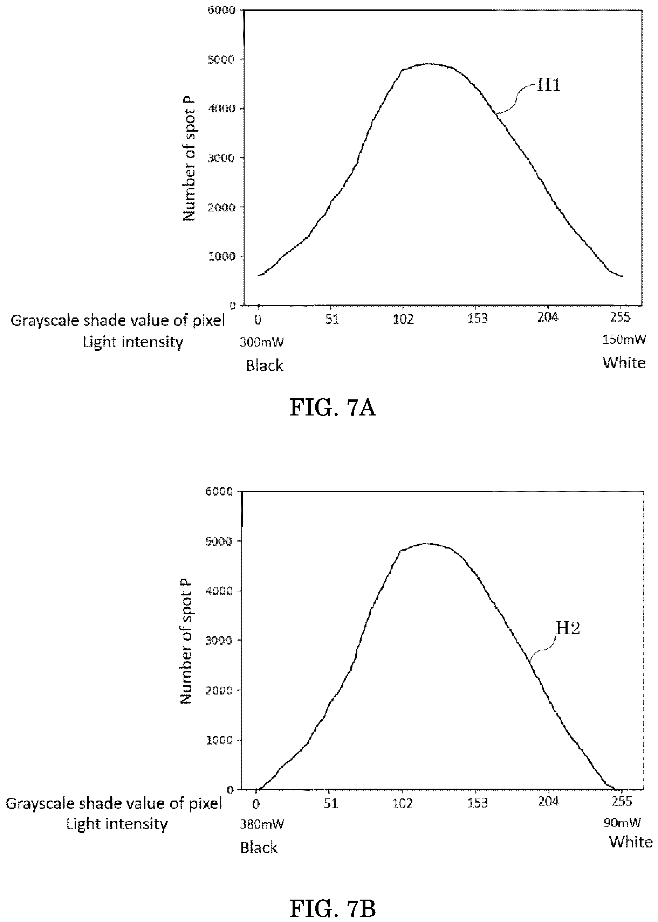

First, examples in which the light source intensity range of the light source 2 is set from the first light source intensity range to the second light source intensity range will be described with reference to FIG. 6A, FIG. 6B, FIG. 7A, and FIG. 7B. Note that, in the examples illustrated in FIG. 6A, FIG. 6B, FIG. 7A, and FIG. 7B, the emission quantity of the emission substance SB entering the detector 5 is not changed from the first value. In the example illustrated in FIG. 6A, it is assumed that the first light source intensity range is the widest intensity range that can be taken by the light source 2, for example, 0 mW to 450 mW. Further, the grayscale value corresponding to light source intensity data of 450 mW at the irradiated spot P is set to 0, and the grayscale value corresponding to light source intensity data of 0 mW at the irradiated spot P is set to the maximum grayscale value 255. The histogram obtained by adjusting the light source intensity within the first light source intensity range is denoted as H1. In the example illustrated in FIG. 6A, the lower grayscale value side (for example, grayscale values 0 to about 40) and the higher grayscale value side (for example, 205 to 255) are not used in the histogram H1. Therefore, in the example illustrated in FIG. 6A, the second light source intensity range can be set as described in (1) or (2) below.
(1) When the frequency of appearance of the irradiated spot P having the light source intensity data corresponding to grayscale value 0 (Black) is 0, the maximum value of the second light source intensity range is set smaller than the maximum value of the first light source intensity range. For example, in the example illustrated in FIG. 6A, grayscale values 0 to about 40 (that is, the larger side in the first light source intensity range) are not effectively used. Thus, the maximum value of the second light source intensity range is set to 380 mW, for example.
(2) When the frequency of appearance of the irradiated spot P having the light source intensity data corresponding to the maximum grayscale value (255) is 0, the minimum value of the second light source intensity range is set larger than the minimum value of the first light source intensity range. For example, in the example illustrated in FIG. 6A, grayscale values 205 to 255 (that is, the smaller side in the first light source intensity range) are not effectively used. Thus, the minimum value of the second light source intensity range is set to 90 mW, for example.

The second detection data output step is then performed with the second light source intensity range set based on the first histogram calculation step described above (for example, 90 mW to 380 mW). Performing the second detection data output step after changing the first light source intensity range, with which the first detection data output step has been performed, to the second light source intensity range is a novel step that is not disclosed in Patent Literature 2.

After the second detection data output step is performed, a second histogram calculation step may be optionally and additionally performed. The second histogram calculation step can, based on the number of grayscale values and on the light source intensity range set in the second detection condition, allocate grayscale values within the grayscale range to respective light source intensities in the light source intensity range or allocate light source intensities within the light source intensity range to respective grayscale values to set grayscale value-light source intensity correlation values that associate light source intensities with grayscale values and thereby calculate the frequency of appearance of irradiated spot P having the grayscale value-light source intensity correlation values from the second detection data. The second histogram calculation step has the same procedure as the first histogram calculation step except that the light source intensity range set in the second detection condition is used. FIG. 6B illustrates an example of a histogram H2 in which grayscale value 0 is set for 380 mW, which is the maximum value of the second light source intensity range, and the maximum grayscale value 255 is set for 90 mW, which is the minimum value of the second light source intensity range. Note that the histogram H2 illustrated in FIG. 6B is not a graph obtained from calculation by changing the first light source intensity range to the second light source intensity range. The histogram H2 illustrated in FIG. 6B is required to be calculated based on the second detection data obtained by the second electron beam irradiation step (ST2c), the second detection step (ST2d), the second light amount adjustment step (ST2e), and the second output step (ST2f) after the second light source intensity range has been set as the second detection condition.

FIG. 7A and FIG. 7B illustrate examples in which settings opposite to the examples illustrated in FIG. 6A and FIG. 6B are applied. In the example illustrated in FIG. 7A, it is assumed that the first light source intensity range has been set to a smaller range (for example, 150 mW to 300 mW) than the widest intensity range that can be taken by the light source 2 (for example, 0 mW to 450 mW is assumed). Further, the grayscale value corresponding to the light source intensity data of 300 mW at the irradiated spot P is set to 0, and the grayscale value corresponding to the light source intensity data of 150 mW at the irradiated spot P is set to the maximum grayscale value 255. The histogram obtained by adjusting the light source intensity within the first light source intensity range is denoted as H1. In the example illustrated in FIG. 7A, since the frequencies of appearance at the irradiated spot P having the light source intensity data corresponding to grayscale value 0 and the maximum grayscale value are greater than 0 in the histogram H1, there are so-called whiteout state and blackout state. Therefore, in the example illustrated in FIG. 7A, the second light source intensity range can be set as described in (3) or (4) below.
(3) When the frequency of appearance of the irradiated spot P having the light source intensity data corresponding to grayscale value 0 (Black) is greater than 0, the maximum value of the second light source intensity range is set larger than the maximum value of the first light source intensity range. For example, when the maximum value of the first light source intensity range is 300 mW, it is possible to eliminate the blackout state by increasing the maximum value of the second light source intensity range to be larger than 300 mW (380 mW in the example illustrated in FIG. 7B), as illustrated in H2 of FIG. 7B.
(4) When the frequency of appearance of the irradiated spot P having the light source intensity data corresponding to the maximum grayscale value (255) is greater than 0, the minimum value of the second light source intensity range is set smaller than the minimum value of the first light source intensity range. For example, when the minimum value of the first light source intensity range is 150 mW, it is possible to eliminate the whiteout state by reducing the maximum value of the second light source intensity range to be smaller than 150 mW (90 mW in the example illustrated in FIG. 7B), as illustrated in H2 of FIG. 7B. The second histogram calculation step may be performed optionally and additionally also in the examples illustrated in FIG. 7A and FIG. 7B.

The settings described in (1) to (4) above can be set so that any one of these settings is included based on the setting value of the first light source intensity range and the calculated histogram.

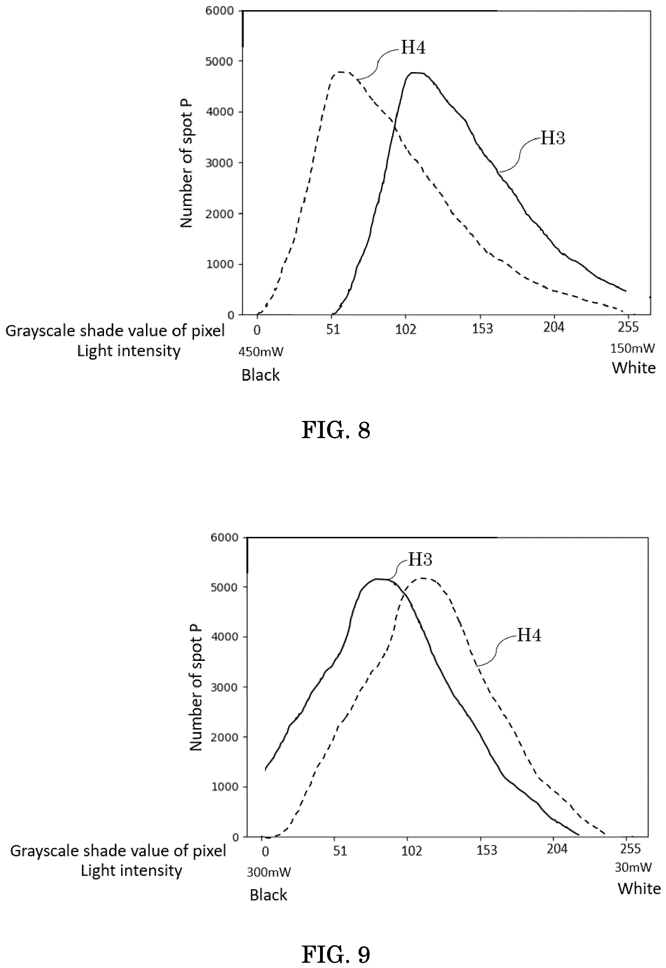

Next, examples of setting the emission quantity of the emission substance SB entering the detector 5 from the first value to the second value will be described with reference to FIG. 8 and FIG. 9. Note that, in the examples illustrated in FIG. 8 and FIG. 9, the intensity of the light source 2 is not changed from the first light source intensity range (150 mW to 450 mW in the examples illustrated in FIG. 8 and FIG. 9). Further, the grayscale value corresponding to the light source intensity data of 450 mW at the irradiated spot P is set to 0, and the grayscale value corresponding to the light source intensity data of 150 mW at the irradiated spot P is set to the maximum grayscale value 255. In the example illustrated in FIG. 8, the histogram obtained by adjustment so that the emission quantity of the emission substance SB entering the detector 5 within the first light source intensity range becomes the first value is denoted as H3. In the example illustrated in FIG. 8, while the lower grayscale value side is not used, the higher grayscale value side is in a so-called whiteout state in the histogram H3. Therefore, in the example illustrated in FIG. 8,
(5) the emission quantity of the emission substance SB entering the detector 5 is set larger than the first value, and thereby the peak position of the frequency of appearance of the irradiated spot P is moved to the grayscale value 0 side, as illustrated in H4.

In the example illustrated in FIG. 8, by increasing the emission quantity of the emission substance SB entering the detector 5, it is possible to effectively use the lower grayscale value side and count the frequency of appearance of the irradiated spot P in more detail even for the portion that has been in the whiteout state.

The reason why the histogram H3 is shifted closer to the histogram H4 by increasing the emission quantity of the emission substance SB entering the detector 5 to be larger than the first value is as follows.
(a) Based on the number of grayscale values and the first light source intensity range in composing an image of the irradiated region R, respective grayscale values in the grayscale range set for respective light source data are not changed in the example illustrated in FIG. 8.
(b) The fact that the emission quantity of the emission substance SB entering the detector 5 is larger than the first value in terms of the same irradiated spot P means that the electron beam irradiated on the same irradiation spot P is stronger, in other words, the light source intensity data obtained from the same irradiated spot P is larger.
(c) As described in (a) above, the light source intensity data set for respective grayscale values in the grayscale range are not changed. Therefore, when the light source intensity data obtained from the same irradiated spot P is larger, the histogram is shifted toward the lower grayscale value (Black) side where the set light source intensity data are larger.

FIG. 9 illustrates an example in which settings opposite to the example illustrated in FIG. 8 are applied. In the example illustrated in FIG. 9, a histogram obtained by adjustment so that the emission quantity of the emission substance SB entering the detector 5 within the first light source intensity range (30 mW to 300 mW) becomes the first value is denoted as H3. In the example illustrated in FIG. 9, while the lower grayscale value side is in a so-called blackout state, the higher grayscale value side is not used in the histogram H3. Therefore, in the example illustrated in FIG. 9,
(6) the emission quantity of the emission substance SB entering the detector 5 is set smaller than the first value, and thereby the peak position of the frequency of appearance of the irradiated spot P is moved to the maximum grayscale value side, as illustrated in H4.

In the example illustrated in FIG. 9, by reducing the emission quantity of the emission substance SB entering the detector 5, it is possible to effectively use the higher grayscale value side and count the frequency of appearance of the irradiated spot P in more detail even for the portion that has been in the blackout state. Note that the second value described in (5) or (6) above can be determined with consideration as to what degree the second value is to be changed from the first value in accordance with the calculated histogram.

Note that, in the present specification, setting of "emission quantity of the emission substance entering the detector" can be performed by the control unit 6. The "emission quantity of the emission substance entering the detector" is set in the control unit 6, and thereby the control unit 6 controls the intensity of the electron beam B irradiated on the irradiation region R, in other words, controls the intensity of the light source 2. Whether or not the emission quantity of the emission substance SB entering the detector 5 has changed from the first value to the second value can be determined by observing the detection signal output from the detector 5.

In the second detection condition setting step (ST2b), the setting of the second light source intensity range described in any of (1) to (4) above and the setting of the second value described in (5) or (6) above may be combined. Note that the settings of the second detection conditions described in (1) to (6) above are performed via a setting method specific to the case where the photocathode 3 is used as a source of releasable electrons, and the image adjustment function generally provided in the electron beam applicator may be optionally and additionally combined therewith.

The second electron beam irradiation step (ST2c) is to irradiate the irradiation region R of the irradiation target S with the electron beam B formed in response to receiving light from the light source 2 based on the set second detection condition. When the first light source intensity range has not been changed in the second detection condition, the electron beam B can be formed within the first light source intensity range. When the first light source intensity range has been changed to the second light source intensity range in the second detection condition, the electron beam B can be formed within the second light source intensity range.

The second detection step (ST2d) is to determine, by the detector 5, the emission quantity of the emission substance SB emitted from the irradiation region S irradiated with the electron beam B and generate a detection signal.

The second light amount adjustment step (ST2e) is to adjust the amount of light reaching the photocathode 3 from the light source 2 within the range of the second detection condition so that the emission quantity of the emission substance SB entering the detector 5 becomes the value of the second detection condition. The amount of light reaching the photocathode 3 from the light source 2 is adjusted so that the first value is applied when the emission quantity of the emission substance SB entering the detector 5 has not been changed from the first value as the second detection condition or so that the second value is applied when the emission quantity has been changed to the second value as the second detection condition. Note that, when the first light source intensity range has not been changed in the second detection condition, the amount of light is adjusted within the first light source intensity range, and when the first light source intensity range has been changed to the second light source intensity range in the second detection condition, the amount of light is adjusted within the second light source intensity range. The specific method of adjusting the amount of light may be the same as that of the first light amount adjustment step (ST1c).

The second electron beam irradiation step (ST2c), the second detection step (ST2d), and the second light amount adjustment step (ST2e) are then repeated until the emission quantity of the emission substance SB entering the detector 5 becomes the value of the second detection condition (the first value or the second value) . In the second output step (ST2f), the light amount adjustment data when the emission quantity of the emission substance SB entering the detector 5 becomes the value of the second detection condition is output as the second detection data of the irradiated region R.

The data output in the second output step (ST2f) is data obtained based on the second detection condition and thus can be said to be data created with more effective use of the grayscale range than the first detection data. Therefore, the second detection data can be used as the detection data of the irradiated region R. Note that the first detection data may be created with effective use of substantially the entire grayscale range. In such a case, the second detection data obtained with the second detection condition can be used as data for verification. For example, when the first detection data is created with effective use of substantially the entire grayscale range, the second detection data obtained by setting the second detection condition with a slight change from the first light source intensity range and/or from the first value can be compared with the first detection data. When it is verified that the first detection data is created with effective use of the grayscale range, the first detection data can be used as detection data of the irradiated region **R.** When verification operation is performed, the second histogram calculation step can be performed by using the second detection data after the second detection data output step. Obviously, since the second detection data is the data created with more effective use of the grayscale range than the first detection data as described above, the second histogram calculation step is not necessarily required to be performed when the second detection data is used as the detection data of the irradiated region R without change.

Further, although not illustrated in the drawings, n-2 times of detection data output steps may be added after the second detection data output step, where n is an integer of 3 or 4 or greater. In the example illustrated in FIG. 4, in the second detection data output step, the detection condition is changed from that in the first detection data output step, and thereby data created with effective use of the grayscale range is obtained. However, it is expected that there is a case where data created with more effective use of the grayscale range than the second detection data is required or a case where verification as to whether or not data created with effective use of the grayscale range is obtained is requested while fine adjustment being made on the detection condition. By adding n-2 times of the detection data output steps after the second detection data output step, it is possible to obtain data created with more effective use of the grayscale range and verify whether or not such data can be obtained. The value n is not particularly limited as long as it is an integer of 3 or 4 or greater and may be set as appropriate.

The n-th detection data output step includes:
an (n-1)-th histogram calculation step of, based on the number of grayscale values and a light source intensity range set in the (n-1)-th detection condition, allocating grayscale values within a grayscale range to respective light source intensities in the light source intensity range or allocating light source intensities within the light source intensity range to respective grayscale values to set grayscale value-light source intensity correlation values, which associate light source intensities with grayscale values, and calculating frequencies of appearance of irradiated spots P having respective grayscale value-light source intensity correlation values from the (n-1)-th detection data,
an n-th detection condition setting step of, to enable effective use of the grayscale range, based on a calculated histogram, setting the light source 2 to have an n-th light source intensity range and/or setting the emission quantity of the emission substance SB entering the detector 5 to an n-th value,
an n-th electron beam irradiation step of, based on a set n-th detection condition, irradiating the irradiation region R of the irradiation target S with an electron beam B formed in response to receiving light from the light source 2,
an n-th detection step of detecting, by the detector 5, data on the emission quantity of the emission substance emitted from respective irradiated spots P in the irradiation region R irradiated with the electron beam B and generating a detection signal,
an n-th light amount adjustment step of adjusting an amount of light reaching the photocathode 3 from the light source 2 within a range of the n-th detection condition so that the emission quantity of the emission substance SB entering the detector 5 becomes a value of the n-th detection condition,
a step of repeating the n-th electron beam irradiation step, the n-th detection step, and the n-th light amount adjustment step until the emission quantity of the emission substance SB entering the detector 5 becomes the value of the n-th detection condition, and
an n-th output step of outputting light amount adjustment data as n-th detection data of the irradiated region R, the light amount adjustment data being obtained when the emission quantity of the emission substance SB entering the detector 5 becomes the value of the n-th detection condition, and
when n is an integer of 4 or greater, the n-th detection data output step is performed n-2 times sequentially from n=3.

The n-th detection data output step is performed n-2 times between the second output step (ST2f) and "END" in FIG. 4. The "(n-1)-th histogram calculation step", "n-th detection condition setting step", "n-th electron beam irradiation step", "n-th detection step", "n-th light amount adjustment step", "step of repeating", and "n-th output step" included in the n-th detection data output step are the same as "first histogram calculation step (ST2a)", "second detection condition setting step (ST2b)", "second electron beam irradiation step (ST2c)", "second detection step (ST2d)", "second light amount adjustment step (ST2e)", "step of repeating", and "second output step (ST2f)" in the second detection data output step, respectively, in terms of operations to be performed. Therefore, detailed description for the n-th detection data output step will be omitted.

When the n-th detection data output step is performed, the n-th detection data can be used as the detection data of the irradiated region R. Note that, when the n-th detection data is used as data for verification, the first detection data to the (n-1)-th detection data may be used as the detection data of the irradiated region R.

The electron beam applicator and the detection data creation method (hereafter, referred to as "electron beam applicator") disclosed in the present application achieve the following advantageous effects.
(1) In the electron beam applicator disclosed in the present application, when composing an image from detection data, the electron beam applicator itself can output detection data created with effective use of a grayscale range. Therefore, data reflecting the sample state of the irradiated region R in more detail can be provided.
(2) When composing an image from detection data, it is possible to improve the contrast of the composed image.

### [Embodiment of Image Composition Method for Irradiation Target in Electron Beam Applicator]

Next, the embodiment of an image composition method for an irradiation target in the electron beam applicator will be described. The image composition method includes an image composition step of compositing an image of the irradiated region R of the irradiation target S from detection data obtained by the embodiment of the detection data creation method.

Typically, in SEM images, an image is composed in accordance with an emission quantity of the emission substance SB emitted from the irradiated spot P (for example, the quantity of secondary electrons). That is, an image at a position where the emission quantity is smaller will be darker, and an image at a position where the emission quantity is larger will be brighter. In contrast, in the detection data creation method according to the embodiment, since the intensity of the light source 2 is adjusted so that the value of the emission quantity of the emission substance SB entering the detector 5 is constant, the light source intensity is higher at a position with a smaller emission quantity of the emission substance SB emitted from the irradiated spot P. Therefore, the detection data (the n-th detection data) of the irradiated region output in the creation method of detection data according to the embodiment can be used without change for the purpose of calculating the frequency of appearance of the irradiated spot P in the histogram calculation step. However, when detection data is imaged as it stands, a black-and-white inverted image from a typical SEM image results. Thus, to compose the same image as a typical SEM image by using detection data, an image can be composed so that the light source intensities in the detection data are inverted.

### [Embodiment of Program and Storage Medium]

The embodiment of the electron beam applicator and the detection data creation method described above can be implemented by the control of the control unit 6 of the electron beam applicator 1. Therefore, it is only required that a program created so as to enable execution of each step illustrated in FIG. 4 (including the n-th detection data output step) be installed in the control unit 6. Further, the program may be provided by being stored in the readable storage medium. By installing the program disclosed in the present application in the control unit 6 of the conventional electron beam applicator 1, it is possible to implement the detection data creation method for the irradiated region R in accordance with the novel principle disclosed in the present application.

Although Examples will be presented below to specifically describe the embodiment disclosed in the present application, these Examples are only for the purpose of illustration of the embodiment and are not intended to limit or restrict the scope of the invention disclosed in the present application.

### [EXAMPLES]

### [Fabrication of Electron Beam Applicator 1]

### <Example 1>

A laser source (iBeamSmart by Toptica) was used for the light source 2. For the photocathode 3, an InGaN photocathode was fabricated by a known method described in Daiki SATO et al. 2016 Jpn. J. Appl. Phys. 55 05FH05. EA treatment on the photocathode surface was performed in accordance with a known method. An electron gun portion of a commercially available SEM was replaced with the fabricated electron gun portion. Note that, in the specification of the commercially available SEM, a cold field emission electron source (CFE) was used for the electron gun, and a deflection coil was provided as the electron beam deflector 8. Electron beam acceleration voltage of 30 kv at the maximum and observation at magnification of 1 million times at the maximum are possible. The program was created and improved so that the control unit 6 of the electron beam applicator 1 can implement each step described in the embodiment.

### <Comparative Example 1>

The electron beam applicator 1 was fabricated in the same manner as in Example 1 except that the program of the control unit 6 was not modified.

### [Implementation of Creation Method of Detection Data and Image Composition Method]

### <Comparative Example 2>

### <<First detection data output step>>

The electron beam applicator 1 fabricated in Example 1 was used to irradiate the irradiation target S with the electron beam B. The amount of light of the light source 2 was then adjusted so that the emission quantity of the emission substance SB entering the detector 5, which was determined by the detector 5, became a preset value (a value causing a detection signal to be the same regardless of the position in the irradiated region R (first value)). The light amount adjustment data when the emission quantity of the emission substance SB entering the detector 5 became the preset first value was output as the first detection data of the irradiated region. Note that the experiment conditions were as follows.
- Acceleration voltage: 0.8 kV
- Magnification: 3,000x
- Intensity of the light source 2 was modulated between 0 mW and 450 mW
- Detection signal target value (first value): -1.58 V

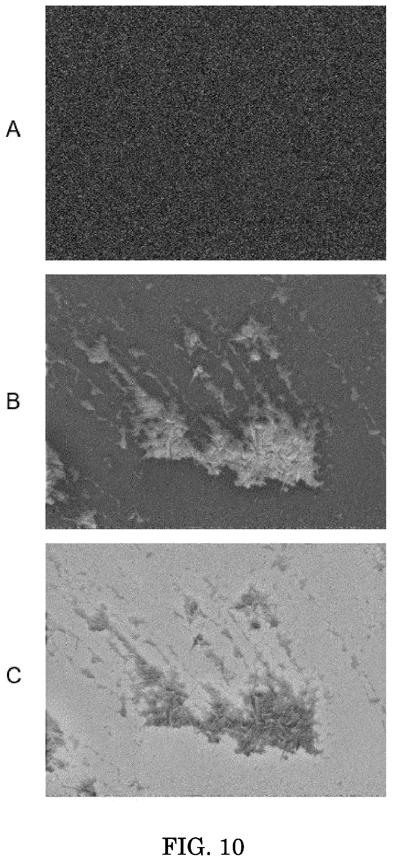

FIG. 10A illustrates a SEM image based on the detection signal output from the detector 5. FIG. 10B illustrates an image composed based on the first detection data. FIG. 10C illustrates an image composed by inverting the light source intensities in the first detection data (hereafter, referred to as "SEM equivalent image of Comparative example 2").

### <Example 2>

### <<Second detection data output step>>

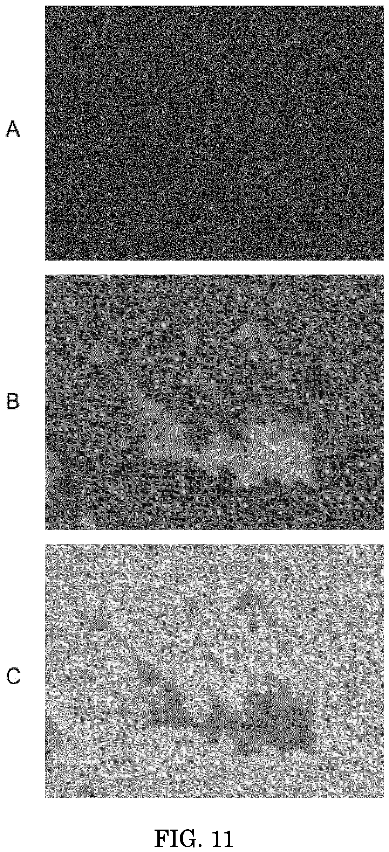

The light amount adjustment data was obtained and output as the second detection data of the irradiated region in the same procedure as in Comparative example 2 except that the light source 2 was modulated in a range of 100 mW to 300 mW based on the histogram calculated in Comparative example 2. FIG. 11A illustrates a SEM image based on the detection signal output from the detector 5. FIG. 11B illustrates an image composed based on the second detection data. FIG. 11C illustrates an image composed by inverting the light source intensities in the second detection data (hereafter, referred to as "SEM equivalent image of Example 2").

Since the emission quantity of the emission substance SB entering the detector 5 has been set to be the first value in advance, the detection signal output from the detector 5 has the same constant value. Therefore, it was confirmed that, as illustrated in FIG. 10A and FIG. 11A, the SEM image based on the detection signal output from the detector 5 was monotone. In contrast, it was confirmed that, as illustrated in FIG. 10B and FIG. 10C and FIG. 11B and FIG. 11C, black-and-white inverted images can be composed between the images composed based on the first and second detection data and the images (SEM equivalent images) having inverted light source intensities in the first and second detection data.

### <Comparative Example 3>

The electron beam applicator fabricated in Comparative example 1 was used to capture SEM images of the irradiation target S in the conventional procedure. Note that the experiment conditions were as follows.
- Acceleration voltage: 0.8 kV
- Magnification: 3,000x
- Probe current: 4 pA (current in acquisition of a SEM image)

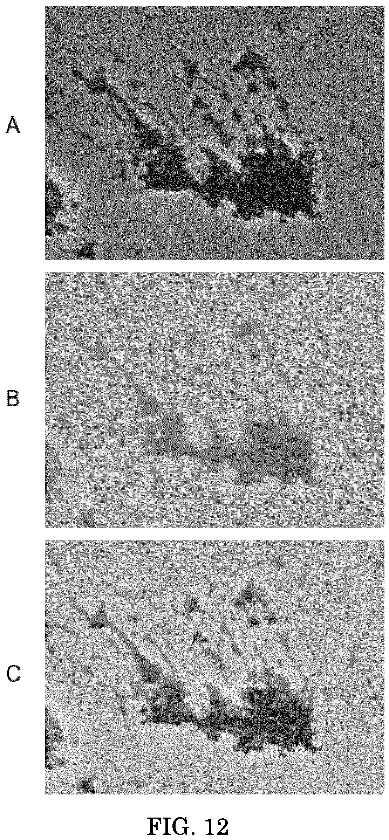

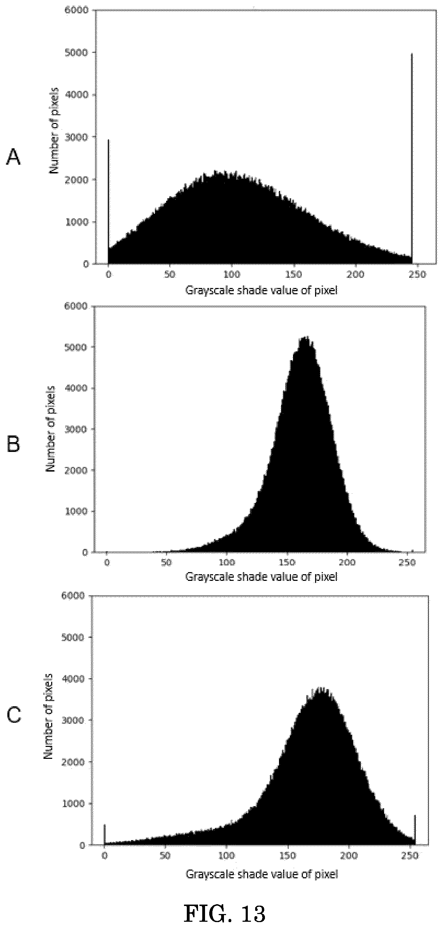

FIG. 12A illustrates a SEM image captured in Comparative example 3. Further, for comparison, FIG. 12B illustrates the SEM equivalent image of Comparative example 2, and FIG. 12C illustrates the SEM equivalent image of Example 2. Further, FIG. 13A illustrates the frequencies of appearance of pixels corresponding to respective grayscale values of the grayscale range of 0 to 255 in the SEM image of FIG. 12A, FIG. 13B illustrates the frequencies of appearance of pixels corresponding to respective grayscale values of the grayscale range of 0 to 255 in the SEM equivalent image of FIG. 12B, and FIG. 13C illustrates the frequencies of appearance of pixels corresponding to respective grayscale values of the grayscale range of 0 to 255 in the SEM equivalent image of FIG. 12C.

As is apparent from FIG. 12, it was confirmed that, with the use of the detection data disclosed in the present application, composition of the same image as conventional SEM images can be made, and a SEM equivalent image having a high contrast created with effective use of a grayscale range is obtained compared to a case where only the first detection data disclosed in Patent Literature 2 is used to compose a SEM equivalent image.

Further, as is apparent from FIG. 13B and FIG. 13C, it was confirmed that, with the use of the second detection data where the first light source intensity range has been changed to the second light source intensity range, composition of a SEM equivalent image with effective use of a grayscale range, in other words, detection data with effective use of a grayscale range can be created by the creation method of detection data disclosed in the present application.

Furthermore, as is apparent from FIG. 10B and FIG. 11B, the contrast of an image composed based on the first detection data and the second detection data changed. This means that a change in the light source intensity range caused a change in the quantity of the emission substance obtained from the irradiated spot P. Therefore, it was confirmed that the detection data obtained by the creation method of detection data disclosed in the present application can be used in the histogram calculation step without being actually imaged.

### <Example 3>

### <<Second detection data output step>>

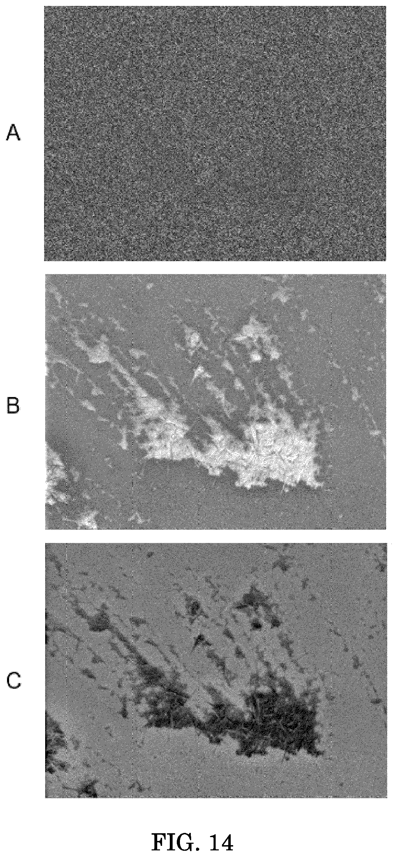

Light amount adjustment data was obtained and output as the second detection data of the irradiated region in the same procedure as in Comparative example 2 except that only the detection signal target value was changed from "-1.58 V" to "-0.65 V" based on the histogram calculated in Comparative example 2. Note that the detection signal target means a numerical value on the SEM control panel, and the detection signal target value described in Example 3 corresponds to setting the emission quantity of the emission substance entering the detector 5 disclosed in the present application to be larger than the first value (the value in Comparative example 2). FIG. 14A illustrates a SEM image based on the detection signal output from the detector 5. FIG. 14B illustrates an image composed based on the second detection data. FIG. 14C illustrates an image composed by inverting the light source intensities in the second detection data (hereafter, referred to as "SEM equivalent image of Example 3").

### <Example 4>

### <<Second detection data output step>>

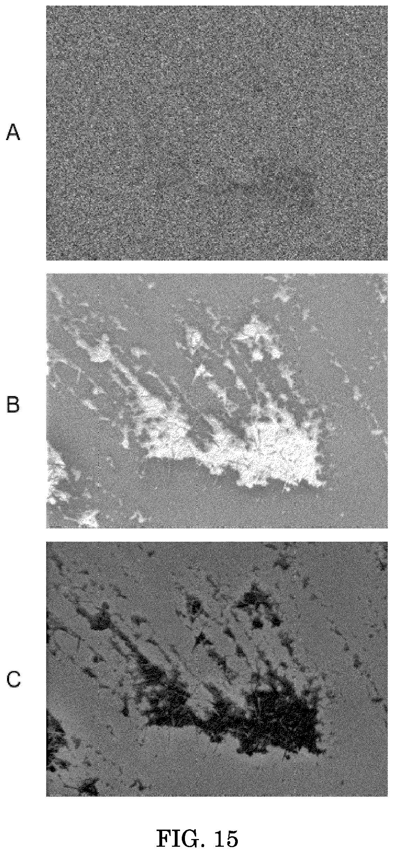

Light amount adjustment data was obtained and output as the second detection data of the irradiated region in the same procedure as in Comparative example 2 except that only the detection signal target value was changed from "-1.58 V" to "-0.18 V" based on the histogram calculated in Comparative example 2. FIG. 15A illustrates a SEM image based on the detection signal output from the detector 5. FIG. 15B illustrates an image composed based on the second detection data. FIG. 15C illustrates an image composed by inverting the light source intensities in the second detection data (hereafter, referred to as "SEM equivalent image of Example 4").

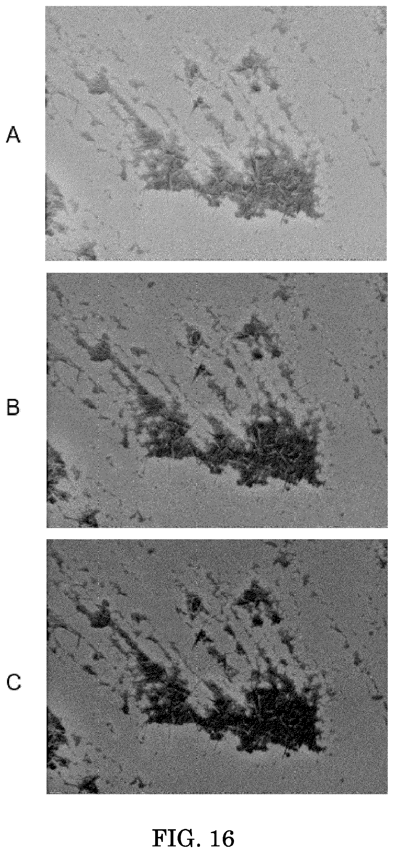

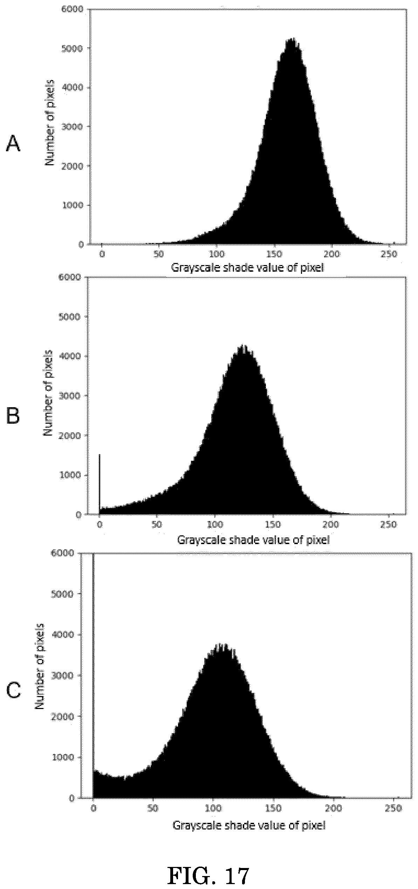

Further, for comparison, FIG. 16A illustrates the SEM equivalent image of Comparative example 2, FIG. 16B illustrates the SEM equivalent image of Example 3, and FIG. 16C illustrates the SEM equivalent image of Example 4. Further, FIG. 17A illustrates the frequencies of appearance of pixels corresponding to respective grayscale values of the grayscale range of 0 to 255 in the SEM equivalent image of FIG. 16A, FIG. 17B illustrates the frequencies of appearance of pixels corresponding to respective grayscale values of the grayscale range of 0 to 255 in the SEM equivalent image of FIG. 16B, and FIG. 17C illustrates the frequencies of appearance of pixels corresponding to respective grayscale values of the grayscale range of 0 to 255 in the SEM equivalent image of FIG. 16C.

As illustrated in FIG. 17, it was confirmed that, by setting the emission quantity of the emission substance SB entering the detector 5 in ascending order of Comparative example 2, Example 3, and Example 4, it is possible to move the peak position of the frequency of appearance of pixels in the grayscale range to the grayscale value 0 side more in Example 4 than in Example 3 from the position in Comparative example 2. Further, as illustrated in FIG. 16, it was confirmed that, by adjusting the emission quantity of the emission substance SB entering the detector 5, it is possible to adjust the brightness of a SEM equivalent image. Further, similarly, it was confirmed from FIG. 14B and FIG. 15B that the detection data obtained by the creation method of detection data disclosed in the present application can be used in the histogram calculation step without being actually imaged.

According to the above results, it was confirmed that, by calculating the frequencies of appearance of the irradiated spot P having respective grayscale value-light source intensity correlation values based on the first detection data and by changing the light source intensity range of the light source 2 and/or changing the emission quantity of the emission substance SB entering the detector 5 based on the calculated histogram, it is possible for the electron beam applicator itself to output detection data created with effective use of the grayscale range. Therefore, even when a correction process or the like are performed on a created image, a more suitable image correction process can be performed due to a wide grayscale range included in the original image.

### [Industrial Applicability]

According to the creation method of detection data and the image composition method for an irradiation target in an electron beam applicator, the program, the storage medium, and the electron beam applicator disclosed in the present application, the electron beam applicator itself can output detection data created with effective use of a grayscale range. Therefore, the creation method of detection data and the image composition method for an irradiation target in an electron beam applicator, the program, the storage medium, and the electron beam applicator disclosed in the present application are useful for business entities that perform inspection, image capturing, or the like of the sample state of an electronic microscope, an electron beam inspection device, or the like.

### [List of References]

- 1: electron beam applicator
- 1a: electron gun portion
- 1b: counterpart device
- 2: light source
- 21: light amount adjustment member
- 3: photocathode (cathode)
- 4: anode
- 5: detector
- 6: control unit
- 7: power supply
- 8: electron beam deflector
- B: electron beam
- C: circuit
- CB: vacuum chamber
- L: excitation light
- P: irradiation spot (irradiated spot)
- R: irradiation region (irradiated region)
- S: irradiation target
- SB: emission substance
- ST1a: first electron beam irradiation step
- ST1b: first detection step
- ST1c: first light amount adjustment step
- ST1d: first output step
- ST2a: first histogram calculation step
- ST2b: second detection condition setting step
- ST2c: second electron beam irradiation step
- ST2d: second detection step
- ST2e: second light amount adjustment step
- ST2f: second output step

## Claims

1. A creation method of detection data in an electron beam applicator,
wherein the electron beam applicator includes
a light source,
a photocathode configured to generate releasable electrons in response to receiving light from the light source,
an anode configured to form an electric field between the photocathode and the anode and extract the releasable electrons by the formed electric field to form an electron beam,
a detector configured to determine an emission quantity of an emission substance emitted from an irradiation target irradiated with the electron beam, and
a control unit,
the creation method of detection data comprising at least two times of detection data output steps,
wherein a first detection data output step includes
a first electron beam irradiation step of irradiating an irradiation region of the irradiation target with an electron beam formed in response to receiving light from the light source set to have a first light source intensity range,
a first detection step of determining, by the detector, the emission quantity of the emission substance emitted from respective irradiated spots in the irradiation region irradiated with the electron beam and generating a detection signal,
a first light amount adjustment step of adjusting an amount of light reaching the photocathode from the light source within the first light source intensity range so that an emission quantity of an emission substance entering the detector becomes a preset first value,
a step of repeating the first electron beam irradiation step, the first detection step, and the first light amount adjustment step until the emission quantity of the emission substance entering the detector becomes the preset first value, and
a first output step of outputting light amount adjustment data as first detection data of the irradiated region, the light amount adjustment data being obtained when the emission quantity of the emission substance entering the detector becomes the first value, and
wherein a second detection data output step includes
a first histogram calculation step of, based on the number of grayscale values in composing an image of the irradiated region or the number of grayscale values in a composed image of the irradiated region and the first light source intensity range, allocating grayscale values within a grayscale range to respective light source intensities in the first light source intensity range or allocating light source intensities within the first light source intensity range to respective grayscale values to set grayscale value-light source intensity correlation values, which associate light source intensities with grayscale values, and calculating frequencies of appearance of irradiated spots having respective grayscale value-light source intensity correlation values from the first detection data,
a second detection condition setting step of, to enable effective use of the grayscale range, based on a calculated histogram, setting the light source to have a second light source intensity range and/or setting the emission quantity of the emission substance entering the detector to a second value,
a second electron beam irradiation step of, based on a set second detection condition, irradiating the irradiation region of the irradiation target with an electron beam formed in response to receiving light from the light source,
a second detection step of detecting, by the detector, data on the emission quantity of the emission substance emitted from respective irradiated spots in the irradiation region irradiated with the electron beam and generating a detection signal,
a second light amount adjustment step of adjusting an amount of light reaching the photocathode from the light source within a range of the second detection condition so that the emission quantity of the emission substance entering the detector becomes a value of the second detection condition,
a step of repeating the second electron beam irradiation step, the second detection step, and the second light amount adjustment step until the emission quantity of the emission substance entering the detector becomes the value of the second detection condition, and
a second output step of outputting light amount adjustment data as second detection data of the irradiated region, the light amount adjustment data being obtained when the emission quantity of the emission substance entering the detector becomes the value of the second detection condition.

2. The creation method of detection data according to claim 1, wherein the second detection data is used as detection data of the irradiated region.

3. The creation method of detection data according to claim 1 further comprising n-2 times of detection data output step after the second detection data output step, where n is an integer of 3 or 4 or greater,
wherein an n-th detection data output step includes
an (n-1)-th histogram calculation step of, based on the number of grayscale values and a light source intensity range set in the (n-1)-th detection condition, allocating grayscale values within the grayscale range to respective light source intensities in the light source intensity range or allocating light source intensities within the light source intensity range to respective grayscale values to set grayscale value-light source intensity correlation values, which associate light source intensities with grayscale values, and calculating frequencies of appearance of irradiated spots having respective grayscale value-light source intensity correlation values from the (n-1)-th detection data,
an n-th detection condition setting step of, to enable effective use of the grayscale range, based on a calculated histogram, setting the light source to have an n-th light source intensity range and/or setting the emission quantity of the emission substance entering the detector to an n-th value,
an n-th electron beam irradiation step of, based on a set n-th detection condition, irradiating the irradiation region of the irradiation target with an electron beam formed in response to receiving light from the light source,
an n-th detection step of detecting, by the detector, data on the emission quantity of the emission substance emitted from respective irradiated spots in the irradiation region irradiated with the electron beam and generating a detection signal,
an n-th light amount adjustment step of adjusting an amount of light reaching the photocathode from the light source within a range of the n-th detection condition so that the emission quantity of the emission substance entering the detector becomes a value of the n-th detection condition,
a step of repeating the n-th electron beam irradiation step, the n-th detection step, and the n-th light amount adjustment step until the emission quantity of the emission substance entering the detector becomes the value of the n-th detection condition, and
an n-th output step of outputting light amount adjustment data as n-th detection data of the irradiated region, the light amount adjustment data being obtained when the emission quantity of the emission substance entering the detector becomes the value of the n-th detection condition, and
wherein when n is an integer of 4 or greater, the n-th detection data output step is performed n-2 times sequentially from n=3.

4. The creation method of detection data according to claim 3, wherein n-th output detection data is used as detection data of the irradiated region.

5. The creation method of detection data according to claim 1, wherein setting of the second light source intensity range includes any one selected from a group consisting of
(1) when the frequency of appearance of an irradiated spot having light source intensity data corresponding to grayscale value 0 is 0, setting the maximum value of the second light source intensity range to be smaller than the maximum value of the first light source intensity range,
(2) when the frequency of appearance of an irradiated spot having light source intensity data corresponding to the maximum grayscale value is 0, setting the minimum value of the second light source intensity range to be larger than the minimum value of the first light source intensity range,
(3) when the frequency of appearance of an irradiated spot having light source intensity data corresponding to grayscale value 0 is greater than 0, setting the maximum value of the second light source intensity range to be larger than the maximum value of the first light source intensity range, and
(4) when the frequency of appearance of an irradiated spot having light source intensity data corresponding to the maximum grayscale value is greater than 0, setting the minimum value of the second light source intensity range to be smaller than the minimum value of the first light source intensity range.

6. The creation method of detection data according to claim 1, wherein setting of the second value includes
(5) when moving a peak position of the frequency of appearance of an irradiated spot to the grayscale value 0 side, setting the emission quantity of the emission substance entering the detector to be larger than the first value, or
(6) when moving a peak position of the frequency of appearance of an irradiated spot to the maximum grayscale value side, setting the emission quantity of the emission substance entering the detector to be smaller than the first value.

7. The creation method of detection data according to any one of claims 1 to 6, wherein the electron beam applicator is
a scanning electron microscope,
an electron beam inspection device,
an Auger electron spectrometer,
a cathodoluminescence device,
an X-ray analyzer,
a transmission electron microscope, or
a scanning transmission electron microscope.

8. An image composition method for an irradiation target in an electron beam applicator, the image composition method comprising:
an image composition step of composing an image of an irradiated region of the irradiation target from detection data obtained by the creation method of detection data according to any one of claims 1 to 6.

9. A program that causes the control unit of the electron beam applicator to perform each step according to any one of claims 1 to 6.

10. A computer readable storage medium storing the program according to claim 8.

11. An electron beam applicator comprising:
a light source;
a photocathode configured to generate releasable electrons in response to receiving light from the light source;
an anode configured to form an electric field between the photocathode and the anode and extract the releasable electrons by the formed electric field to form an electron beam;
a detector configured to determine an emission quantity of an emission substance emitted from an irradiation target irradiated with the electron beam; and
a control unit,
wherein the program according to claim 9 is stored in the control unit.

12. The electron beam applicator according to claim 11, wherein the control unit implements control to perform an image composition step of composing an image of an irradiated region of the irradiation target from the detection data.

13. The electron beam applicator according to claim 11, wherein the electron beam applicator is
a scanning electron microscope,
an electron beam inspection device,
an Auger electron spectrometer,
a cathodoluminescence device,
an X-ray analyzer,
a transmission electron microscope, or
a scanning transmission electron microscope.
